Europäisches Patentamt

European Patent Office

Office européen des brevets

(19)

(11) Veröffentlichungsnummer: **0 181 286**

**A1**

(12) # EUROPÄISCHE PATENTANMELDUNG

(21) Anmeldenummer: **85810495.3**

(51) Int. Cl.⁴: **H 05 K 9/00**

(22) Anmeldetag: **29.10.85**

(30) Priorität: **29.10.84 CH 5162/84**

(43) Veröffentlichungstag der Anmeldung:
**14.05.86 Patentblatt 86/20**

(84) Benannte Vertragsstaaten:
**AT BE CH DE FR GB IT LI NL SE**

(71) Anmelder: **Autophon A.G.**
**Ziegelmattstrasse 1-15**
**CH-4500 Solothurn 3(CH)**

(72) Erfinder: **Keller, Martin**
**Kapfstrasse 13**
**CH-8625 Gossau(CH)**

(74) Vertreter: **Schweizer, Hans et al,**
**Bovard AG Patentanwälte VSP Optingenstrasse 16**
**CH-3000 Bern 25(CH)**

(54) **Geschirmte Anordnung zum Störschutz von Nachrichtenleitungen.**

(57) Zwischen dem Eingangsraum 1 und dem Ausgangsraum 10 der durch Boden 8 und Deckel 12 aus Blech geschirmten Störschutz-Anordnung ist eine beidseitig bestückte Leiterplatte 14 eingesetzt. Ein aus Ableiter 16, Kondensatoren 19 und Spulen 21 bestehendes Entstörnetzwerk ist zwischen die Eingangsleitungen 2, 2', die Ausgangsleitungen 11 und die Masseschirme 15, 18 fest eingelötet, geschweisst oder leitend geklebt. Letztere sind auf oder in der Leiterplatte 14 angebracht, mit Löchern 17, 17' durchkontaktiert und bedecken möglichst alle Flächen der Leiterplatte 14, die nicht von Leiterbahnen zu den Netzwerk-Bauteilen 16, 19, 21 belegt sind. Das Ganze ist mit einer Steckdose 2 im Gehäuse 4 des zu schützenden elektronischen Apparates verschraubt und in sich verlötet.

Fig. 1

EP 0 181 286 A1

- 1 -

## Geschirmte Anordnung zum Störschutz von Nachrichtenleitungen

Die Erfindung befasst sich mit einer geschirmten Anordnung zum Störschutz von Nachrichtenleitungen nach dem Oberbegriff des Patentanspruchs 1.

Eine solche Anordnung ist aus der schweizerischen Patentschrift Nr. 644 730 bekannt, welche ein Anschlussgerät für eine Mehrzahl von Fernmeldeleitungen betrifft. An jeder Eingangsleitung ist ein Ableiter angeschlossen, welcher die an der Ausgangsleitung angeschlossenen elektronischen Einrichtungen vor Ueberspannungen extrem schnellen Anstiegs (EMP oder NEMP) schützen soll.

Dieser Ableiter ist in eine Halterung auswechselbar eingeklemmt, welcher einerseits aus einem besonderen Absatz eines massiven metallischen als Masseschirm dienenden Wandelements und anderseits aus einer gewölbten und gebogenen Stahlblattfeder besteht. Letztere ist in einen durch das Wandelement führenden Stutzen eines L-förmigen Isolationskörpers eingesetzt und bildet mit ihren Enden die Anschlüsse für die Eingangs- und Ausgangsleitungen. Der Bodenteil des L-Körpers distanziert und isoliert den Ableiter vom Wandelement.

Diese Anordnung hat den Nachteil, dass speziell geformte Halterungsteile anzufertigen sind, welche überdies bei hohen Ableitströmen durch ihre Kontaktwiderstände die Restspannung erhöhen, besonders beim Masseanschluss des Ableiters.

- 2 -

Es ist allerdings aus der europäischen Patentanmeldung Nr. 92052 bekannt, Ableiter enthaltende Störschutznetzwerke nebeneinander auf der Vorderseite einer Leiterplatte anzuordnen, und parallel zur Rückseite eine grossflächige Metallplatte als Masseschirm vorzusehen. Letztere wird mittels Schraubverbindungen mit den zu erdenden Stellen auf der Leiterplatte verbunden. Nachteilig ist bei dieser flächenhaften Anordnung der relativ grosse Platzbedarf und die langen strahlenden und bestrahlbaren elektrischen Verbindungen.

Es ist Aufgabe der Erfindung, diese Mängel zu beheben und eine platzsparende, einfach herzustellende und elektromagnetisch günstige Anordnung zum Störschutz von Nachrichtenleitungen zu schaffen.

Diese Aufgabe wird durch die im Kennzeichen des Patentanspruchs 1 umschriebenen Massnahmen gelöst. Bei dieser Anordnung erübrigen sich besondere Halterungen für die Ableiter sowie besondere Abschirmwände oder -platten zwischen Eingangs- und Ausgangsraum. Auch ergeben sich sehr kurze Leiter mit wenig Induktivität und Kapazität; ihr Widerstand sowie derjenige der vorzugsweise gelöteten Anschlüsse ist klein und konstant und vermindert die galvanische Kopplung unter den stromführenden Elementen in vorteilhafter Weise.

Die Anordnung nach Patentanspruch 2 trägt noch höheren Anforderungen Rechnung. Die Abschirmung zwischen Eingangs- und Ausgangsräumen ist sowohl räumlich wie elektrisch vervollkommnet und hochfrequenten Störungen kann besser begegnet werden.

- 3 -

In den daran anschliessenden Patentansprüchen sind weitere Ausführungsarten der Erfindung dargelegt.

Die Erfindung wird im folgenden an Hand eines Beispiels erläutert. Es zeigen die Zeichnungen

Fig. 1 einen schematischen Vertikalschnitt der Anordnung, ungefähr entsprechend den strichpunktierten Linie I-I in Fig. 2,
Fig.2 eine Schaltschema einer für diese Anordnung vorgesehenen Leiterplatte.

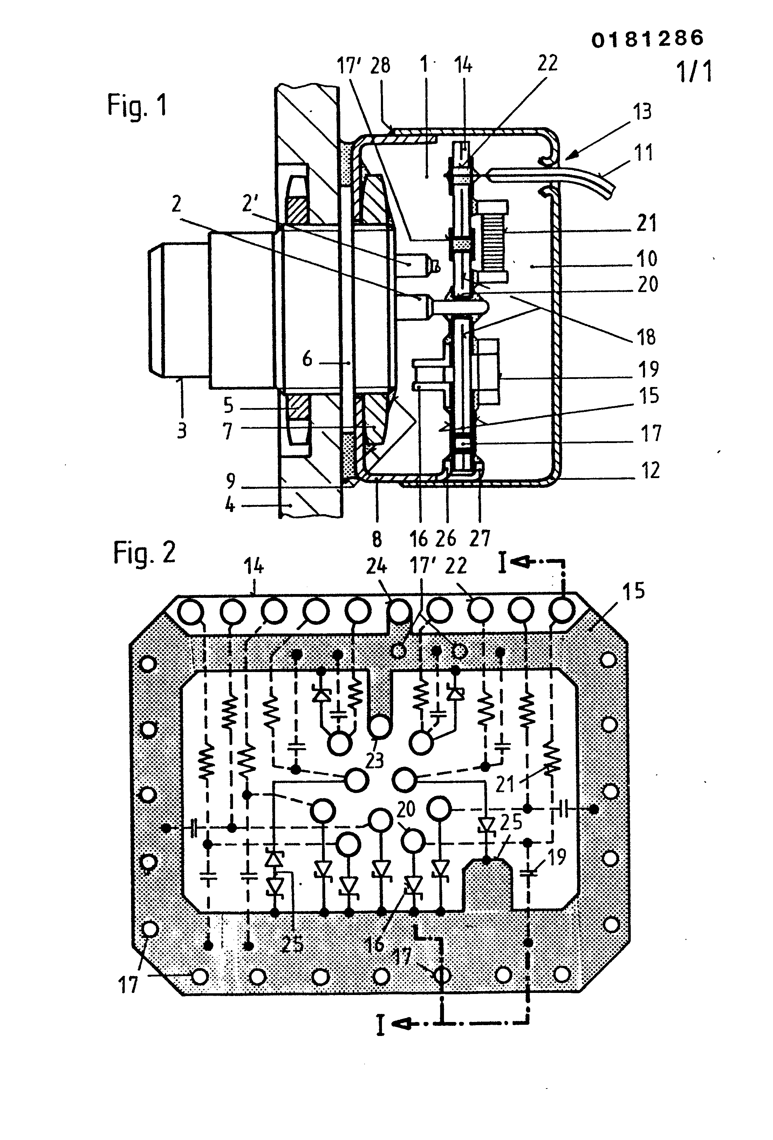

In der Fig. 1 ist eine geschirmte Anordnung zum Störschutz von Nachrichtenleitungen dargestellt. Diese Leitungen sind in einem nicht gezeichneten mehradrigen Kabel mit Stecker enthalten und finden ihre Fortsetzung beim Eintritt in einen Eingangsraum 1 in den nur zum Teil gezeigten Eingangsleitungen, beispielsweise 2 und 2', auf der Innenseite einer Steckdose 3. Diese ist in der massiven leitenden Wand 4 eines nicht weiter veranschaulichten elektronischen Apparates eingesetzt und mit einer Ringmutter 5 gegen den Bund 6 verschraubt. Auf der Innenseite wird durch eine Sechskantmutter 7 ein Boden 8 an der Steckdose 3 befestigt. Ein Ausgangsraum 10 wird von einem die Ausgangsleitungen enthaltenden Bandkabel 11 durchzogen, welches ausserdem einen Deckel 12 beim Schlitz 13 durchstösst. Boden 8 und Deckel 12 sind aus gut leitendem Blech hergestellt und miteinander verlötet, so dass sie einen wirksamen Blechschirm bilden. Auch die anderen vorerwähnten Halte- und Befestigungsteile sind miteinander an den Stellen 9 verlötet.

Gemäss der Erfindung ist nun zwischen dem Eingangsraum 1 und dem Ausgangsraum 10 eine Leiterplatte 14 eingesetzt, an

- 4 -

welcher ein hier dreiteiliger Masseschirm 15, angebracht ist. Auf ihrer dem Eingangsraum 1 zugewandten Seite, zwischen Eingangsleitung 2 und Masseschirm 15, ist ein Ableiter 16 eingelötet. Dieser Ableiter 16 bildet Teil eines LC-Tiefpassfilters, welches als Entstörnetzwerk für die Leitungen 2, 2' ,11 dient. Der Masseschirm 15 besteht ausser den eingangs- und ausgangsseitigen in Löchern 17 und 17' durchkontaktierten Belägen aus einer leitenden Multilayer-Zwischenschicht 18, die ebenfalls an die Metallisierung der Löcher 17, 17' angeschlossen ist. Der Rest des Entstörnetzwerkes ist auf der dem Ausgangsraum 10 zugewandten Seite der Leiterplatte 14 angebracht, nämlich ein Kondensator 19, der direkt auf die Leiterbahnen nach dem Anschlussloch 20 der Eingangsleitung 2 und nach dem Masseschirm 15 gelötet ist, ebenso wie eine Spule 21 auf den Leiterbahnen zwischen demselben Loch 20 und dem Ausgangs-Anschlussloch 22. Entsprechendes gilt für jede in gleicher Weise geschützte Leitung, z.B. auch Leitung 2'.

In dem Schema Fig. 2 der Leiterplatte 14 sind die Verbindungen zu den Ableitern 16 im Eingangsraum 1 (Fig. 1) ausgezogen gezeichnet, diejenigen zu den Kondensatoren 19 und Spulen 21 im Ausgangsraum 10 (Fig. 1) dagegen nur gestrichelt.

Die Eingangsanschlusslöcher 20 sind im Zentrum der Leiterplatte 14 auf einer Kreisfläche so verteilt, wie die Innenanschlussstifte der Eingangsleitungen 2,3' in der Steckdose 3 (Fig. 1), so dass ein geradliniger direkter Anschluss möglich ist. Die Ausgangs-Anschlusslöcher 22 sind am oberen Rand der Leiterplatte 14 in einer geraden Reihe und im Abstand entsprechend den Leitern des Bandkabels 11, (Fig. 1) angeordnet. Je ein Loch 23 bzw. 24 am Eingang und am Ausgang ist über eine Leiterbahn direkt mit dem Massebeleg 15 verbunden. Auch sonst ist angestrebt, alle Masseanschlüsse der Ableiter 16 und Kondensatoren 19 möglichst weit gegen das Zentrum zu führen, wie dies für einen einzigen Ableiter mit der nach innen ragenden Leiterfläche 25 angedeutet ist. Schliesslich können weitere leere Stellen der Leiterplatte 14 mit der gegenseitigen Masseschicht durchverbunden sein, etwa gemäss dem ausgefüllten Kontaktloch 17' (Fig. 1). Dasselbe gilt für die Zwischenschicht 18 (Fig. 1), wie schon erwähnt; diese ist aber in der Fig. 2 zwecks Vereinfachung weggelassen, wie auch der Massebelag 15 der Eingangsseite 1 (Fig. 1). Durch diese Massnahmen wird ein relativ dichter Masseschirm zwischen Eingangs- und Ausgangsraum 1 bzw. 10 (Fig. 1) erreicht.

Für die Bestückung werden vorzugsweise Bauteile 16, 19, 21 für Oberflächenmontage (SMD Surface Mounted Device) vorgesehen. Dabei können bei gewissen Leitungen Ableiter 25 vorgesehen werden, welche zwei gegeneinandergeschaltete Dioden aufweisen, um so positive und negative Störimpulse gleich gut abzuleiten.

Wie aus Fig. 1 ersichtlich, wird die nach Bestücken und Verlöten der Bauteile 16, 19, 21 zur Montage bereitgestellte Leiterplatte 14 auf den entsprechend vorbereiteten Boden 8 und die Innenanschlussstife 2, 2' aufgesetzt. Letzterer besitzt unten und auf beiden Seiten mehrere Haltelappen 26, 27. Die längeren Haltelappen 27 stehen vor dem Aufsetzen der Platte 14 gerade, werden aber nachher gegen diese umgebogen. Beide Haltelappenreihen 26, 27 werden schliesslich mit den Massebelägen 15 verlötet, ebenso die Anschlussstifte 2, 2' mit ihren Löchern 20, 23 bzw. Bandkabel 11 mit den Löchern 22, 24. Nach dem elektrischen Test der Anordnung wird das Bandkabel 11 durch den Schlitz 13 des Deckels 12 gezogen und dieser mit dem Boden 8 am Rand 28 rundum verlötet.

Durch die oben beschriebene Anordnung erhält man einen grösstmöglichen Schutz, sowohl gegen Störungen, die durch die Leitungen 2, 2' eingeschleppt werden, als auch gegen solche aus der Umgebung.

Die Erfindung kann für anders geartete Anforderungen abweichend vom Vorstehenden ausgeführt werden. So können als Begrenzungen der Eingangs- und Ausgangsräume 1 bzw. 10 Teile des Apparategehäuses 4 herangezogen werden, so dass sich Boden 8 und Deckel 12 erübrigen, oder es kann sogar die Verlötung der Steckdose oder diese selbst wegfallen. Auch mögen unter Umständen eine oder zwei der drei Schichten des Masseschirms 15, 18 weggelassen werden oder es kann in einfachsten Fällen gar das Entstörnetzwerk nur aus dem Ableiter 16 bestehen. Anderseits kann die Zahl und Art der Netzwerkglieder und Blechschirme erhöht bzw. verändert werden, um besonderen Anforderungen bezüglich Stärke und Frequenzanteile der Störungen oder bezüglich der Empfindlichkeit des zu schützenden Apparates Rechnung zu tragen. Unter "Blech" sollen in diesem Zusammenhang auch hochleitfähige Kunststoffschichten verstanden werden, unter "Löten" hochleitfähige Klebverbindungen oder Schweissen.

Derartige oder ähnliche fachmännische Abwandlungen werden aber der Kürze halber nicht bis in die Einzelheiten dargestellt.

**Patentansprüche**

1. Geschirmte Anordnung zum Störschutz von Nachrichtenleitungen, wie folgt:

- Zwischen dem Anschluss (20) einer Eingangsleitung
(2,2') und dem Anschluss (22) einer Ausgangsleitung
(11) und einem Masse-Schirm (15,18) ist ein mindestens
einen Ableiter (16) enthaltendes Entstörnetzwerk (16,
19,21) geschaltet;

- der Masseschirm (15,18) schirmt einen von der Eingangsleitung (2,2') durchlaufenen Eingangsraum (1), in
welchem der Ableiter (16) angebracht ist, von einem
von der Ausgangsleitung (11) durchlaufenen Ausgangsraum (10) ab;

wobei die Anordnung dadurch gekennzeichnet ist,

- dass der Masseschirm (15,18) als leitender Belag an
einer Leiterplatte (14) angebracht ist, und dass der
Ableiter (16) auf ihrer dem Eingangsraum (1) zugewandten Eingangsfläche zwischen der Eingangsleitung
(2,2') und dem Masseschirm (15,18) fest angeschlossen
ist.

2. Anordnung nach Patentanspruch 1, wie folgt gekennzeichnet:

- Der Masseschirm (15,18) ist, mittels Löchern (17,17') durchkontaktiert, mindestens auf den Aussenseiten einer beidseitig bestückten Leiterplatte (14) angebracht, welche auf ihrer dem Ausgangsraum (10) zugewandten Fläche den Rest (19,21) des einen Tiefpass bildenden Entstörnetzwerkes (16,19,21) aufweist.

3. Anordnung nach Patentanspruch 2, wie folgt gekennzeichnet:

- Die beiden genannten Räume (1,10) werden ausser von der Leiterplatte (14) von rundum geschlossenen und mit dem Masseschirm (15) verbundenen Blechschirmen (8,12) begrenzt, der Eingangsraum (1) ausserdem von einer in eine Oeffnung des Blechschirms (8) eingesetzten mehrpoligen Steckdose (3) für den Aussenanschluss eines abgeschirmten mehradrigen Kabels und der Ausgangsraum (10) durch einen Schlitz (13) als Durchlass für ein Ausgangsleitungs-Bandkabel (11).

4. Anordnung nach Patentanspruch 3, wie folgt gekennzeichnet:

- Die Eingangsleitungen (2,2') bilden gerade Innenanschlussstifte (2,2') der Steckdose (3) und sind direkt in entsprechenden Eingangslöchern (20) der Leiterplatte (14) eingelötet;

- 9 -

- die Ableiter (16) sind direkt auf Leiterbahnen nach diesen Löchern (20) bzw. nach dem Masseschirm (15) gelötet;

- das Ausgangsleitungs-Bandkabel (11) ist mit seinen Leitern in entsprechenden Ausgangslöchern (22) eingelötet;

- die Kondensatoren (19) von LC-Tiefpässen sind direkt auf Leiterbahnen nach den letzteren Löchern (22) und nach dem Masseschirm (15) und die Spulen (21) dieser Tiefpässe direkt auf Leiterbahnen zwischen den Eingangs- und den Ausgangslöchern (20,22) gelötet.

5. Anordnung nach Patentanspruch 3 dadurch gekennzeichnet, dass ein Boden (8) als Eingangs- und ein Deckel (12) als Ausgangs-Blechschirm vorgesehen sind, die unter sich, mit dem Masseschirm (15,18) und mit dem Steckdosengehäuse (3) verlötet sind.

Fig. 1

Fig. 2

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | EP-A-0 025 195 (SIEMENS) <br> * Seite 4, Zeile 19 - Seite 5, Zeile 10 * | 1,2 | H 05 K  9/00 |
| | --- | | |
| A | FR-A-2 201 592 (SIEMENS) <br> * Seite 1, Zeile 23 - Seite 2, Zeile 2 * | 1,2 | |
| | --- | | |
| A | DE-A-1 466 310 (SIEMENS) <br> * Seite 5, letzter Absatz - Seite 6 * | 3 | |
| | --- | | |
| A | GB-A-2 029 645 (MITSUMI) <br> * Seite 2, Zeilen 5-24 * | 1 | |
| | --- | | |
| A,D | EP-A-0 092 052 (ANT) | | RECHERCHIERTE SACHGEBIETE (Int Cl 4) |
| | --- | | H 05 K <br> H 04 B <br> H 02 H |
| A,D | CH-A- 644 730 (FRISCHKNECHT et al.) | | |
| | --- | | |
| A | EP-A-0 090 774 (FELLER) <br> * Seite 11, letzter Absatz - Seite 12; Figur 3 * | 1 | |
| | ----- | | |

Der vorliegende Recherchenbericht wurde für alle Patentansprüche erstellt

| Recherchenort <br> DEN HAAG | Abschlußdatum der Recherche <br> 03-02-1986 | Prüfer <br> TOUSSAINT F.M.A. |
|---|---|---|